# EUROPÄISCHE PATENTSCHRIFT

(11) **EP 0 970 512 B1**
(45) Veröffentlichungstag und Bekanntmachung des Hinweises auf die Patenterteilung: **11.08.2004**
(21) Anmeldenummer: 98965089.0
(22) Anmeldetag: 23.11.1998
(51) Int. Cl.: H01L 21/00

(54) **VERFAHREN ZUM AUFBRINGEN EINES SCHUTZLACKS AUF EINEN WAFER**
METHOD FOR APPLYING A PROTECTING LACQUER ON A WAFER
PROCEDE POUR L'APPLICATION D'UN VERNIS PROTECTEUR SUR UNE PLAQUETTE

(30) Priorität: 28.11.1997 DE 19752926
(43) Veröffentlichungstag der Anmeldung: 12.01.2000
(73) Patentinhaber: ROBERT BOSCH GMBH, 70442 Stuttgart (DE)
(72) Erfinder: BECKER, Volker, D-76359 Marxzell (DE); LÄRMER, Franz, D-70437 Stuttgart (DE); SCHILP, Andrea, D-73525 Schwäbisch Gmünd (DE)
(86) Internationale Anmeldenummer: PCT/DE1998/003442
(87) Internationale Veröffentlichungsnummer: WO 1999/028954

(56) Entgegenhaltungen:
- US-A- 5 820 677
- PATENT ABSTRACTS OF JAPAN vol. 098, no. 002, 30. Januar 1998 & JP 09 260276 A (HITACHI LTD), 3. Oktober 1997
- PATENT ABSTRACTS OF JAPAN vol. 015, no. 185 (E-1066), 13. Mai 1991 & JP 03 046353 A (NEC CORP), 27. Februar 1991
- PATENT ABSTRACTS OF JAPAN vol. 013, no. 406 (P-930), 8. September 1989 & JP 01 147307 A (SHARP CORP), 9. Juni 1989
- DATABASE WPI Section Ch, Week 8142 Derwent Publications Ltd., London, GB; Class A89, AN 81-76430d XP002102301 & JP 56 110232 A (NIPPON TELEGRAPH & TELEPHONE CORP.), 1. September 1981

## Beschreibung

Die Erfindung betrifft ein Verfahren zum Aufbringen eines Schutzlacks auf einen bereits strukturierten Wafer.

Halbleiterscheiben, sogenannte Wafer, können aus einem Substrat und im Substrat durch Ätzen von der Rückseite erzeugten Membranen bestehen. Als Substratmaterial und damit auch als Material für die Membranen wird vorzugsweise Silizium verwendet. Auf der Wafervorderseite, d.h. der Seite, die die Membranen enthält, müssen in einer Reihe von Sensoranwendungen durch Trockenätzen Strukturen aus den Membranen erzeugt werden. Beim Trockenätzen ist es erforderlich, die Membranunterseiten, die durch Kavernenätzen in dem Substrat von der Rückseite her erzeugt worden sind, während des Trockenätzprozesses, zu schützen.

Dieser Rückseitenschutz erfüllt während der Trockenätzung folgende wesentliche Funktionen, wobei es sich beim Trockenätzen vorzugsweise um ein anisotropes Plasmaätzverfahren handelt.

Der Rückseitenschutz verhindert zum einen, daß Ätzgase, wie z.B. Fluor, nach dem Durchätzen der Vorderseitenmembran die Membranunterseite angreifen können, indem die Kavernen durch die Schutzschicht abgedichtet sind und zusätzlich die Membranunterseiten bedeckt sind, so daß kein freies Silizium auf der Rückseite offenliegt, welches von den Ätzgasen, z.B. Fluor angegriffen werden kann.

Der Rückseitenschutz erlaubt auch ein Überätzen bereits durchgeätzer Strukturen im Plasma, d.h. es kommt zu einer Verringerung des Ätzangriffs auf die Siliziumseitenwände von aus der Membran bereits fertig geätzten Strukturen dadurch, daß deren Unterseiten geschützt werden.

Ferner wird die Waferrückseite abgedichtet, die beim Plasmaätzen zur Substratkühlung zur Vorderseite hin mit Helium als Konvektionsmedium beaufschlagt werden muß. Diese Kühlung bleibt somit auch nach dem partiellen Durchätzen der Vorderseitenmembran erhalten, da das Helium aufgrund des Rückseitenschutzes nicht in das Kammervolumen der Vakuumanlage entweichen kann.

Desweiteren kommt es zu einer Stabilisierung des Wafers und einem mechanischen Schutz der nach dem Durchätzen fragilen Strukturen durch den Rückseitenlack. Sogar im extremen Falle eines Bruchs des Wafers durch die fragilen Kavernenbereiche ist sichergestellt, daß ein angebrochener Wafer noch als Ganzes aus der Plasmaätzkammer ausgeschleust werden kann und keine Bruchstücke auf der Substratelektrode liegen bleiben, was eine aufwendige Reinigung der Plasmaätzanlage nach sich ziehen würde.

Schließlich kann der Rückseitenschutz als definierter Ätzstopp dienen. Da die Siliziumätzung stoppt, wenn die Lackschicht erreicht wird, kann das Erreichen der Lackschicht mittels eines Endpunkterkennungssystems mit optischer Emissionsspektroskopie (OES = optical Emission Spectroscopy) festgestellt werden. Ohne Lack würde die Siliziumätzung auf der Rückseite fortschreiten, d.h. es gäbe keinen detektierbaren Endpunkt.

Der Rückseitenschutz muß jedoch zusätzlich folgenden Bedingungen genügen:

Der Schutzlack darf nur innerhalb der Kavernen verbleiben und sich nicht auf die übrige Waferrückseite erstrecken, damit der Wafer nicht auf der Substratelektrode oder an den Komponenten der Schleusenvorrichtung anklebt oder diese verschmutzen kann.

Der Schutzlack darf ferner während des Plasmaätzverfahrens, wo er thermisch belastet wird, nicht aufblühen oder abplatzen, damit eine Kontaminierung der Substratelektrode oder der Einschleusvorrichtungen vermieden wird und die Abdichtung der heliumbeaufschlagten Waferrückseite zum Kammervolumen gewährleistet bleibt.

Desweiteren sollte eine ausreichende Selektivität gegenüber dem Positivabdecklack bestehen, der sich beim Plasmaätzen üblicherweise auf der Vorderseite zur Strukturdefinition befindet, damit der Rückseitenabdecklack in den Kavernen oder als Schutz lokaler Bereiche nicht beeinträchtigt wird, wenn der Positivabdecklack der Vorderseite bei der Photolithographie entwickelt oder zwischendurch oder zum Schluß entfernt wird.

Bisher wurde versucht, den Rückseitenschutz dadurch zu erreichen, daß ein Positivabdecklack ganzflächig auf der Rückseite des Wafers aufgetragen und photolithographisch so strukturiert wurde, daß er nur in den Kavernen, nicht jedoch auf der übrigen Waferrückseite verblieb. Der Einsatz von Positivlack an dieser Stelle ist jedoch nicht zielführend. Negativabdecklacke und vor allem nichtphotostrukturierbare Polymere ließen sich auf diese Weise nicht zuverlässig aufbringen und auf das Kaverneninnere beschränken. Gerade die beispielsweise gegenüber Flußsäuredampf widerstandsfähigsten Lacke sind jedoch aufgrund des Fehlens funktioneller Gruppen, was für die Dichtigkeit gegenüber HF wesentliche Voraussetzung ist, nicht photostrukturierbar.

Der Einsatz eines Positivabdecklacks zur Kavernenbefüllung ist ferner mit folgenden Problemen verbunden: Er muß sehr dick aufgeschleudert und anschließend photostrukturiert, d.h. belichtet und entwickelt, werden. Dazu muß ein klebriger, d.h. auf der Rückseite nicht vollständig ausgeheizter bzw. ausgehärteter Wafer durch entsprechende Lithographieeinrichtungen gehandhabt werden. Dicker Positivabdecklack blüht jedoch wegen des Gehalts an Lösungsmitteln und flüchtiger unvernetzter Monomere leicht beim Trocknen und bei höheren Temperaturen auf, wobei er dazu neigt, von den Kavernenunterseiten großflächig abzuplatzen. Ferner wird die Handhabung wegen der zunächst ganzflächigen klebrigen Waferrückseite sehr erschwert. Dies ist die Folge des dicken sich bei diesem Verfahren dort zunächst überall befindlichen Lacks.

Da aufgrund des identischen Lacktyps keine ausreichende Selektivität zwischen dem Vorderseitenabdecklack und dem Rückseitenabdecklack besteht, kommt es beim Entwickeln des Vorderseitenabdecklacks zu Schwierigkeiten, da z.B. durch den Entwickler für das partielle Ablösen des Vorderseitenabdecklacks beim Entwicklungsprozeß auch der Rückseitenabdecklack stark mitangegriffen wird. Das Entsprechende gilt, wenn der Vorderseitenabdecklack später ganzflächig entfernt werden soll, möglichst ohne den Rückseitenschutz zu schädigen. Dabei kommt es ebenfalls zu einer Schädigung des Rückseitenschutzes, so daß der Wafer z.B. nicht weiterprozessiert werden kann, falls noch Folgeschritte erforderlich wären.

Der Positivabdecklack kann auch keine Heliumdichtigkeit oder einen ausreichenden Rückseitenschutz nach dem Durchätzen der Membranen liefern, da er im Plasma aufgrund der damit verbundenen thermischen und chemischen Belastung aufblüht und undicht wird.

Die Aufgabe vorliegender Erfindung besteht daher darin, ein Verfahren bereitzustellen, das die geschilderten Nachteile des Standes der Technik überwindet.

Erfindungsgemäß wird ein Verfahren zum Aufbringen eines Schutzlacks auf einen vorstrukturierten Wafer bereitgestellt, das dadurch gekennzeichnet ist, daß das Aufbringen mittels einer Verteilervorrichtung erfolgt, die eine Aufnahmeeinrichtung für den Wafer, eine xy-Verschiebeeinheit mit Programmiergerät und ein Dosiergerät aufweist. Eine ähnliche Vorrichtung ist beispielsweise aus JP09260276 oder JP01147307 bekannt. Durch das Dosiergerät wird der optimale Schutzlack und die optimale Menge an Schutzlack gezielt in die Kavernen dosiert.

In einer bevorzugten Ausführungsform der Erfindung wird der Schutzlack in mikromechanisch vorstrukturierte Kavernen auf die Waferrückseite aufgebracht.

Weiter bevorzugt ist der Einsatz eines Negativabdecklacks oder eines Lacks aus nichtphotostrukturierbaren Polymeren als Schutzlack. Hierbei kann vorzugsweise Benzocyclobutadien, Polymethylmethacrylat, Polyimid oder Epoxid verwendet werden. Negativabdecklacke sind durch ihre hohe chemische und thermische Stabilität besonders vorteilhaft und können trotzdem später sauber und Mokstandsfrei entfernt werden, z.B. in einem Sauerstoffplasma.

Die Verteilervorrichtung besteht im wesentlichen aus folgenden drei Bestandteilen:
1. Sie weist eine Aufnahmeeinrichtung für die Wafer auf, so daß diese in genau definierter Weise reproduzierbar hinsichtlich der Plattenorientierung in der Verteilervorrichtung positioniert werden. Dies wird beispielsweise durch einen Teller erreicht mit einer der Wafergeometrie entsprechenden, eingefrästen Aussparung, die auch den Waferflat einschließt. Damit wird die Position und die Ausrichtung der Wafer eindeutig festgelegt.
2. Die Verteilervorrichtung umfaßt ferner eine xy-Verschiebeeinheit mit Programmiergerät, die die eigentliche Spritzvorrichtung trägt und jede einzelne Kavernenposition gezielt anfahren kann und so die ganze Waferrückseite programmgesteuert abrastert. Jede Kaverne des Wafers entspricht einer explizit eingegebenen Programmposition.
3. Schließlich weist die Verteilervorrichtung ein Dosiergerät auf, das elektrisch mit dem Programmiergerät verbunden ist und von diesem gesteuert wird, d.h. eine Vorrichtung, die per Programmbefehl eine genau definierte Lackmenge aus einer Spritze durch eine nadelförmige Düse abspritzen kann. Die abgespritzte Lackmenge kann vorherbestimmt werden über den angelegten Spritzdruck, den Düsenquerschnitt und die vorprogrammierte Spritzdauer. Ein Nachtropfen von Lack nach dem Ende des Spritzvorgangs wird vorzugsweise dadurch verhindert, daß unmittelbar danach ein Unterdruck angelegt wird, der den Lack aus der Düse sofort nach dem Abspritzen wieder zurückzieht. Damit wird zuverlässig verhindert, daß Lacktropfen auf die Waferrückseite außerhalb der Kavernen gelangen können.

Diese speziell an das erfindungsgemäße Verfahren angepaßte verteilervorrichtung fährt eine Kavernenposition an, spritzt eine vorgewählte Lackmenge in die jeweilige Kaverne ab, bestätigt das Ende des Spritzvorgangs an das Programmiergerät, wonach die nächste Kaverne angefahren und der Vorgang wiederholt wird, bis alle Kavernen des Wafers gefüllt sind. Hierbei wird bei Programmbeginn zunächst in einer Ruheposition mehrmals, beispielsweise fünfmal in ein Auffanggefäß gespritzt, um die Düse in einen definierten Anfangszustand zu versetzen und insbesondere angetrocknete oder verdickte Lackreste aus der Düse zu entfernen. Danach passiert die Nadel einen Lackabstreifer, um einen eventuell an der Nadel verbliebenen Lacktropfen vor Erreichen der Waferfläche abzustreifen und ebenfalls dem Auffanggefäß zuzuführen. Dieser Abstreifer ist im einfachsten Fall der Rand des Lackauffanggefäßes selbst, das in diesem Fall genauso hoch sein muß, daß es das Nadelende ohne Berührung überstreichen läßt, jedoch einen an der Nadel hängenden Lacktropfen beim Passieren abstreift. Beim Programmende fährt die Vorrichtung wiederum in eine Endposition, die identisch mit der anfangs angefahrenen Ruheposition sein kann, aber nicht muß.

Mittels der Verteilervorrichtung, die jede Kavernenposition auf der Rückseite eines Wafers per xy-Verschiebetisch programmgesteuert anfährt und dort mittels einer Spritzvorrichtung eine genau bestimmte Lackmenge deponiert, wird erreicht, daß alle Rückseitenkavernen gleichmäßig mit einer frei wählbaren Menge an Schutzlack gefüllt werden, ohne die waferrückseite an anderer Stelle mit Lack zu kontaminieren. Es ist auch möglich, jeder Kaverne eine individuelle Lackmenge zuzuführen, besonders wenn es sich um unterschiedlich große Kavernen handelt.

In einer weiteren bevorzugten Ausführungsform ist der Wafer auf seiner Vorderseite mit einem Positivabdecklack beschichtet.

Bei dem erfindungsgemäßen Verfahren können die Kavernen der Waferrückseite mit Hilfe der Verteilervorrichtung selektiv belackt werden, wobei bevorzugt ein Negativlack oder ein Lack eingesetzt wird, der gegenüber den Entwicklern oder Lösungen zum partiellen oder vollständigen Entfernen für den Positivabdecklack der Vorderseite resistent ist. Dadurch kann eine Vorderseiten-Lithographie, Vorderseiten-Lacknachbehandlung oder -entfernung erfolgen ohne Beeinträchtigung des Waferrückseitenschutzes, der so für Folgeprozesse intakt erhalten bleibt.

Der Negativabdecklack hat gegenüber dem Positivabdecklack den Vorteil, daß er chemisch und thermisch sehr stabil ist, so daß er weder beim Ausheizen noch beim anschließenden Plasmaätzen aufblüht oder abplatzt, so daß die Schutzwirkung voll gewährleistet bleibt und z.B. ein Kontaminationsrisiko für die Substratelektrode des Plasmaätzgeräts nicht besteht. Außerdem kann der Plasmaätzprozess zuverlässig geführt werden, da die Waferdichtigkeit und die Schutzwirkung garantiert ist und ein Endpunktsignal mittels OES (optische Emissionsspektroskopie) definiert ist.

In einer weiteren bevorzugten Ausführungsform erfolgt das Aufbringen des Schutzlacks mittels des Dosiergeräts in einem einzigen oder mehreren Spritzvorgängen pro Kaverne. Die Spritzvorgänge können zusätzlich aus unterschiedlichen Positionen über den Kavernen erfolgen. Dies hat den Vorteil, daß die Kavernen möglichst gleichmäßig gefüllt werden können. Dazu kann in einem Durchlauf mehrmals in jede Kaverne gespritzt werden, oder man verwendet mehrere Durchläufe über den Wafer.

Es kann auch erforderlich werden, insbesondere bei schwierigen Kavernentopographien, unterschiedliche Bereiche der Kavernen jeweils selektiv mit Lack zu versehen. Es ist ebenfalls möglich, das gesamte Spritzprogramm jeweils mehrmals über ein und demselben Wafer anzuwenden, gegebenenfalls unter Berücksichtigung von Offsets, um verschiedene Kavernenpositionen zu erreichen. Dabei können pro Programmablauf bzw. -durchlauf auch unterschiedliche Lacke eingesetzt werden. Es ist beispielsweise möglich, beim ersten Programmdurchlauf einen dünnen, jedoch auf Silizium sehr gut haftenden Lack abzuspritzen und beim zweiten Programmdurchlauf dann einen dickeren Lack zu verwenden, der als solcher direkt auf Silizium schlecht haften würde, sich aber eben dick auftragen läßt. Durch den ersten Lackauftrag des dünnen Lacks ergibt sich jedoch insgesamt für das Lackschichtsystem eine sehr gute Haftung auf Silizium, weil der zweite Lack gut auf dem ersten und dieser wiederum gut auf Silizium haftet.

Bei den verfahrensgemäß eingesetzten Negativabdecklacken und Positivabdecklacken handelt es sich um in der Halbleitertechnik und Mikromechanik übliche kommerzielle Lacke, die beispielsweise von den Firmen OCG, KTI Chemicals oder Hoechst vertrieben werden.

Durch das erfindungsgemäße Verfahren ist es in überaus vorteilhafter Weise nunmehr möglich, für die Rückseitenbelackung einen Negativabdecklack oder andere polymere Lacke einzusetzen, die gegenüber den Entwickler- oder Entfernungslösungen für den Positivabdecklack der Wafervorderseite resistent oder weitgehend resistent sind. Damit kann der Positivabdecklack photostrukturiert, entwickelt oder auch zum Schluß ganz entfernt werden, ohne den Rückseitenschutz zu schädigen. Insbesondere ist es nunmehr auch möglich, nichtphotostrukturierbare Schutzlacke einzusetzen, die z.B. gegenüber Flußsäure oder anderen chemischen Reagenzien besonders resistent sind. Die Negativabdecklacke und die gegenüber den Entwickler- oder Entfernungslösungen resistenten Lacke haben den Vorteil, daß sie beim Ausheizen nicht aufblühen, im hart ausgebackenen Zustand sehr gut haften, gegenüber dem Positivabdecklack äußerst selektiv sind und während des Plasmaätzens nicht aufschäumen und keine Kontamination der Substratelektrode des Plasmaätzgeräts bewirken. Darüber hinaus haben diese Abdecklacke eine hohe mechanische Festigkeit, so daß sie den Wafer nach dem Durchätzen stabilisieren können und auch dem Heliumrückseitendruck zur Waferkühlung während des Plasmaätzens zuverlässig standhalten. Besonders vorteilhaft ist auch die gute Stabilität gegen die beim Plasmaätzen auftretenden Fluorradikale des Plasmaätzgases.

In einer weiteren Ausführungsform kann der Schutzlack auch auf vorbestimmte Bereiche auf bestimmten vorstrukturierten Wafervorderseiten aufgebracht werden, um diese beispielsweise vor einem aggressiven Medium zu schützen. Bei diesen Bereichen handelt es sich beispielsweise um solche von vergrabenen Leiterbahnen und/oder Kontaktflächen, die vor einem aggressiven Medium, z.B. Flußsäure, in Folgeprozessen geschützt werden sollen.

Beispielsweise ist es auf diese Weise möglich, Bereiche der Vorderseite selektiv mit einem Negativabdecklack oder anderen, z.B. nichtphotostrukturierbaren Lacken, zu schützen. Das kann z.B. vor der Opferschichtätzung in Flußsäuredampf geschehen, wenn das Opferoxid in einzelnen Bereichen erhalten bleiben, also geschützt werden, soll. Dies kann z.B. im Bereich von durch Siliziumdioxid vergrabenen Leiterbahnen oder von Kontaktflächen aus elektrischen Isolationsgründen notwendig sein, um Leckströme zu vermeiden. Bei vorstrukturierten Wafervorderseiten ist es mit anderen Verfahren, z.B. Aufschleudern und Photolithographie, praktisch nicht mehr möglich, eine selektive Bedeckung genau der zu schützenden Bereiche zu erreichen.

Vorzugsweise rastert die Verschiebeeinheit die Wafervorder- oder -rückseite programmgesteuert ab. Es ist jedoch auch möglich, daß die Positionen zum Aufbringen des Lacks mittels elektronischer Bildverarbeitung identifiziert und angesteuert werden. Das heißt, anstelle einer exakten Positionierung des Wafers in einer präzisen Aufnahmevorrichtung ist es dann auch möglich, den Wafer einfach relativ grob in der Prozeßstation abzulegen und die Kavernenpositionen per elektronischer Bildverarbeitung zu identifizieren und anzusteuern. Mittels Bildverarbeitung kann auch gleichzeitig eine Qualitätskontrolle für den Spritzerfolg durchgeführt werden, d.h. man prüft nach, ob bestimmte Belackungsbilder erhalten wurden.

Die Bildverarbeitung stellt zwar einen höheren elektronischen Aufwand dar, macht aber die explizite Programmierung jeder einzelnen Kavernenposition in weiterer vorteilhafter Ausgestaltung der Erfindung überflüssig, indem einfach jede vom Programm vorgefundene und "elektronisch" identifizierte Kaverne bespritzt wird. Es ist dann nicht mehr nötig, die Programmpositionen an den eingelegten Wafer individuell anzupassen, vielmehr sucht sich das Programm selbst seine Kavernenpositionen über die Bildverarbeitung, was unter Fertigungsbedingungen einen wesentlichen Gewinn an Flexibilität darstellt und zur Vermeidung von Fehlern beiträgt. Es ist sogar möglich, daß das Programm automatisch die Kavernengröße erkennt und individuell jeder Kaverne die für ihre Größe optimale Menge an Lack zudosiert.

Es ist weiter möglich, anstelle der manuellen Einbringung der Wafer in die Vorrichtung diese mit einem automatischen Beladesystem zu kombinieren. Dieses kann beispielsweise aus einer Kassettenstation Wafer für Wafer wiederum äußerst genau in die Prozeßposition einbringen bzw. nach Prozeßende daraus wieder abtransportieren. Man kann auch ein weniger genaues automatisches Handlingsystem einsetzen und dieses mit einer elektronischen Bildverarbeitung zur Identifikation und Ansteuerung der einzelnen Kavernen einsetzen, wie beschrieben.

Die Erfindung soll anhand beigefügter Zeichnung näher erläutert werden.

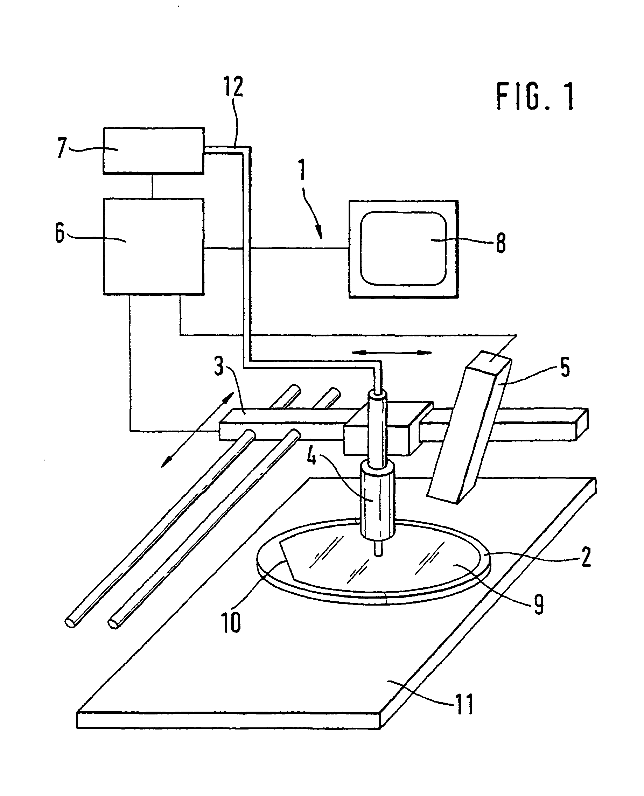

Hierbei zeigt die Fig. 1 die Verteilervorrichtung 1, mittels der das erfindungsgemäße Verfahren zum Aufbringen des Schutzlacks 15, 17 auf den vorstrukturierten Wafer 9 erfolgt. Die Verteilervorrichtung 1 weist eine Aufnahmeeinrichtung 2 für den Wafer 9 auf, so daß dieser in genau definierter Weise reproduzierbar mit der Plattenorientierung in der Verteilervorrichtung 1 positioniert wird. Die Aufnahmeeinrichtung 2 kann die Form eines Tellers haben mit einer der Wafergeometrie entsprechenden, eingefrästen Aussparung, die auch den Waferflat 10 einschließt, wodurch die Position und die Ausrichtung des Wafers 9 eindeutig festgelegt wird. Die Aufnahmeeinrichtung 2 für den Wafer 9 befindet sich auf dem Tisch 11. Die Verteilervorrichtung 1 umfaßt ferner eine xy-Verschiebeeinheit 3, an der ggf. die Videokamera 5 des Bildverarbeitungssystems befestigt ist. Das Programmiergerät 6 steuert die xy-Verschiebeeinheit 3, das Dosiergerät 7 (Spritzbefehle und Rückmeldung) sowie ggf. die Bildverarbeitung und den Bildschirm 8. Das Dosiergerät 7 erzeugt per Programmbefehl aus dem Programmiergerät 6 kurzzeitig einen Überdruck, was zum Abspritzen führt, oder einen Unterdruck, was zum Rücksaugen des Lackes führt. Hierbei wirkt der Über- bzw. Unterdruck über den Schlauch 12 auf die Spritze 4, welche mit Lack gefüllt ist und über eine Dosiernadel auf den Wafer 9 spritzt.

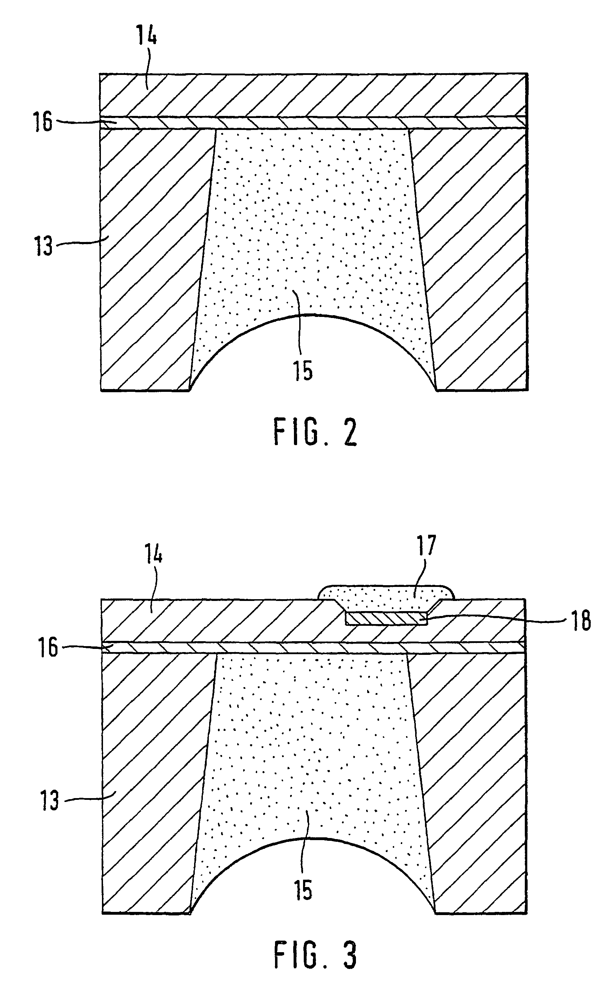

Die Fig. 2 zeigt einen mit der in Fig. 1 dargestellten verteilervorrichtung 1 prozessierten Waferausschnitt im Querschnitt.

Darin ist mit 13 eine Kavernenwand des aus Silizium bestehenden Wafers bezeichnet. Die Kaverne ist mit dem Rückseitenschutzlack 15 befüllt. Auf dem Wafer befindet sich die ebenfalls aus Silizium bestehende Membran 14. Diese Membran 14 kann direkt aus dem Wafermaterial hergestellt sein, oder durch eine Zwischenschicht 16 vom eigentlichen Substratwafer getrennt sein. Die Zwischenschicht 16 besteht meistens aus SiO₂, was zu einem sogenannten SOI-Waferaufbau (silicon-on-insulator) führt.

Die Fig. 3 zeigt ebenfalls einen mit der in Fig. 1 dargestellten Verteilervorrichtung 1 prozessierten Waferausschnitt im Querschnitt.

Dieser Waferausschnitt entspricht dem in Fig. 2 gezeigten, wobei jedoch zusätzlich ein Vorderseitenschutzlack 17, z.B. desselben Typs wie auf der Rückseite, auf eine vergrabene Leiterbahn oder Kontaktfläche 18 aufgebracht ist.

### Bezugszeichenliste

- 1: verteilervorrichtung
- 2: Aufnahmeeinrichtung für den Wafer
- 3: xy-Verschiebeeinheit
- 4: Spritze
- 5: Videokamera
- 6: Programmiergerät
- 7: Dosiergerät
- 8: Bildschirm
- 9: Wafer
- 10: Waferflat
- 11: Tisch
- 12: Schlauch
- 13: Kavernenwand
- 14: Membran
- 15: Rückseitenschutzlack
- 16: Zwischenschicht
- 17: Vorderseitenschutzlack
- 18: vergrabene Leiterbahn oder Kontaktfläche

## Patentansprüche

1. Verfahren zum Aufbringen eines Schutzlacks auf einen vorstrukturierten Wafer, wobei
das Aufbringen mittels einer Verteilervorrichtung (1) erfolgt, die eine Aufnahmeeinrichtung (2) für den Wafer (9), eine xy-Verschiebeeinheit (3) mit Programmiergerät (6) und ein Dosiergerät (7) mit einer Spritze (4) aufweist.
**dadurch gekennzeichnet.**
**dass** der Schutztack (15) durch eine gezielte Ansteuerung in mikromechanisch vorstrukturierte Kavernen auf die Waferrückseite und/oder dass ein Vorderseitenschutzlack (17) durch eine gezielte Ansteuerung in Vertiefungen auf die Wafervorderseite aufgebracht wird.

2. Verfahren nach Anspruch 1, **dadurch gekennzeichnet, dass** als Schutzlack (15) ein Negativabdecklack oder ein Lack aus nichtphotostrukturierbaren Polymeren eingesetzt wird.

3. Verfahren nach Anspruch 2, **dadurch gekennzeichnet, dass** ein Schutzlack (15) eingesetzt wird, der Benzocyclobutadien, Polymethylmethacrylat, Polyimid oder Epoxid umfasst.

4. Verfahren nach einem der vorangehenden Ansprüche 1 bis 3, **dadurch gekennzeichnet, dass** der Wafer (9) auf seiner Vorderseite mit einem Positivabdecklack beschichtet ist.

5. Verfahren nach Anspruch 4, **dadurch gekennzeichnet, dass** der Abdecklack der Vorderseite photostrukturiert wird.

6. Verfahren nach einem der vorhergehenden Ansprüche 1 bis 5, **dadurch gekennzeichnet, dass** das Aufbringen des Schutzlacks (15) in einer Kaverne und/oder des Vorderseitenschutzlacks (17) in einer Vertiefung der Wafervorderseite mittels des Dosiergeräts (7) mit Spritze (4) in einem einzigen oder mehreren Spritzvorgängen über der Kaverne erfolgt.

7. Verfahren nach Anspruch 6, **dadurch gekennzeichnet, dass** der Spritzvorgang als einmaliger Vorgang oder mehrmals über denselben Wafer erfolgt.

8. Verfahren nach Anspruch 6 oder 7, **dadurch gekennzeichnet, dass** die Spritzvorgänge aus unterschiedlichen Positionen über den Kavernen erfolgen.

9. Verfahren nach einem der vorangehenden Ansprüche 1 bis 8, **dadurch gekennzeichnet, dass** der Schutzlack (17) auf vorbestimmte Bereiche auf die bereits strukturierte Wafervorderseite aufgebracht wird.

10. Verfahren nach Anspruch 9, **dadurch gekennzeichnet, dass** die vorbestimmten Bereiche solche von vergrabenen Leiterbahnen und/oder Kontaktflächen (18) sind.

11. Verfahren nach einem der Ansprüche 1 bis 9, **dadurch gekennzeichnet, dass** die xy-Verschiebeeinheit (3) die Wafervorder- oder -rückseite programmgesteuert abrastert.

12. Verfahren nach einem der Ansprüche 1 bis 11, **dadurch gekennzeichnet, dass** die Positionen zum Aufbringen des Lacks mittels elektronischer Bildverarbeitung identifiziert und angesteuert werden.

13. Verfahren nach einem der Ansprüche 1 bis 12, **dadurch gekennzeichnet, dass** die Kavernengröße mittels elektronischer Bildverarbeitung erfasst und die der Kavernengröße entsprechende Lackmenge jeweils individuell für jede Kaverne zudosiert wird.

## Claims

1. Method for applying a protective resist to a prepatterned wafer, the application being effected by means of a distributor apparatus (1) having a receptacle device (2) for the wafer (9), an xy displacement unit (3) with programming device (6) and a metering device (7) with a syringe (4),
**characterized**
**in that** the protective resist (15) is applied to the rear side of the wafer by means of a targeted driving into micromechanically prepatterned caverns and/or in that a front side protective resist (17) is applied to the front side of the wafer by means of a targeted driving into depressions.

2. Method according to Claim 1, **characterized in that** the protective resist (15) used is a negative covering resist or a resist made of non-photopatternable polymers.

3. Method according to Claim 2, **characterized in that** a protective resist (15) is used which comprises benzocyclobutadiene, polymethyl methacrylate, polyimide or epoxide.

4. Method according to one of the preceding Claims 1 to 3, **characterized in that** the wafer (9) is coated with a positive covering resist on its front side.

5. Method according to Claim 4, **characterized in that** the covering resist of the front side is photopatterned.

6. Method according to one of the preceding Claims 1 to 5, **characterized in that** the application of the protective resist (15) in a cavern and/or of the front side protective resist (17) in a depression of the front side of the wafer is effected by means of the metering device (7) with syringe (4) in a single or a plurality of injection operations over the cavern.

7. Method according to Claim 6, **characterized in that** the injection operation is effected as a single operation or repeatedly over the same wafer.

8. Method according to Claim 6 or 7, **characterized in that** the injection operations are effected from different positions over the caverns.

9. Method according to one of the preceding Claims 1 to 8, **characterized in that** the protective resist (17) is applied to predetermined regions onto the already patterned front side of the wafer.

10. Method according to Claim 9, **characterized in that** the predetermined regions are those of buried interconnects and/or contact areas (18).

11. Method according to one of Claims 1 to 9, **characterized in that** the xy displacement unit (3) scans the front or rear side of the wafer in a program-controlled manner.

12. Method according to one of Claims 1 to 11, **characterized in that** the positions for the application of the resist are identified and driven by means of electronic image processing.

13. Method according to one of Claims 1 to 12, **characterized in that** the cavern size is detected by means of electronic image processing and the quantity of resist corresponding to the cavern size is respectively metered in individually for each cavern.

## Revendications

1. Procédé pour l'application d'un vernis protecteur sur une plaquette préalablement structurée, selon lequel l'application s'effectue au moyen d'un dispositif de répartition (1), qui présente un dispositif de réception (2) pour la plaquette (9), une unité de déplacement xy (3) dotée d'un programmateur (6) et un doseur (7) doté d'une seringue (4),
**caractérisé en ce que**
le vernis protecteur (15) est appliqué par le biais d'une commande ciblée dans des cavités préalablement structurées de façon micromécanique sur la face arrière de la plaquette, et/ou un vernis protecteur de face avant (17) est appliqué dans des renfoncements sur la face avant de la plaquette par une commande ciblée.

2. Procédé selon la revendication 1,
**caractérisé en ce qu'**
on utilise en tant que vernis protecteur (15) un vernis de recouvrement négatif ou un vernis en polymère non photostructurable.

3. Procédé selon la revendication 2,
**caractérisé en ce qu'**
on utilise un vernis protecteur (15) qui comprend du benzocyclobutadiène, du polyméthylméthacrylate, du polyimide ou de la résine époxyde.

4. Procédé selon l'une quelconque des revendications précédentes 1 à 3,
**caractérisé en ce que**
la plaquette (9) est recouverte sur sa face avant d'un vernis de recouvrement positif.

5. Procédé selon la revendication 4,
**caractérisé en ce que**
le vernis de recouvrement de la face avant est photostructuré.

6. Procédé selon l'une des revendications précédentes 1 à 5,
**caractérisé en ce que**
l'application du vernis protecteur (15) dans une cavité et/ou du vernis protecteur de face avant (17) dans un renfoncement de la face avant de la tranche s'effectue au moyen du doseur (7) doté de la seringue (4) au cours d'un ou plusieurs opérations d'injection unique(s) au-dessus des cavités.

7. Procédé selon la revendication 6,
**caractérisé en ce que**
l'opération d'injection s'effectue en tant qu'opération unique ou en plusieurs fois sur la même plaquette.

8. Procédé selon la revendication 6 ou 7,
**caractérisé en ce que**
les opérations d'injection s'effectuent à partir de différentes positions au-dessus des cavités.

9. Procédé selon l'une des revendications précédentes 1 à 8,
**caractérisé en ce que**
le vernis protecteur (17) est appliqué sur des zones prédéterminées sur la face avant de la plaquette préalablement structurée.

10. Procédé selon la revendication 9,
**caractérisé en ce que**
les zones prédéterminées sont telles que celles de pistes conductrices et/ou de surfaces de contact (18) enfouies.

11. Procédé selon l'une des revendications 1 à 9,
**caractérisé en ce que**
l'unité de déplacement xy (3) scanne de façon programmée la face avant ou arrière de la plaquette.

12. Procédé selon l'une des revendications 1 à 11,
**caractérisé en ce que**
les positions d'application du vernis sont identifiées et commandées au moyen d'un traitement électronique de l'image.

13. Procédé selon l'une des revendications 1 à 12,
**caractérisé en ce que**
la taille des cavités est déterminée au moyen d'un traitement électronique de l'image et la quantité de vernis correspondant à la taille des cavités est dosée respectivement individuellement pour chaque cavité.
